Europäisches Patentamt

European Patent Office

Office européen des brevets

(19)

(11) Publication number : **0 411 816 B1**

# (12) EUROPEAN PATENT SPECIFICATION

(45) Date of publication of patent specification :
21.09.94 Bulletin 94/38

(51) Int. Cl.[5] : **G02B 6/12**

(21) Application number : **90308134.7**

(22) Date of filing : **25.07.90**

(54) Tapered semiconductor waveguides and method of making same.

(30) Priority : **03.08.89 US 389087**
**03.08.89 US 389074**

(43) Date of publication of application :
**06.02.91 Bulletin 91/06**

(45) Publication of the grant of the patent :
**21.09.94 Bulletin 94/38**

(84) Designated Contracting States :
**DE DK FR GB IT SE**

(56) References cited :
**US-A- 3 978 426**
**US-A- 4 546 480**
**ELECTRONICS LETTERS. vol. 25, no. 2,**
**January 19, 1989, ENAGE GB pages 128 -130;**
**N. YAMAGUCHI ET AL.: 'Spot size convertor**
**by overlapping of two taperedwaveguides '**

(56) References cited :
**PROCEEDINGS OF THE IEEE. vol. 75, no. 11,**
**November 1987, NEW YORK US pages**
**1472-1483; Y. SUEMATSU et al.: "Integrated**
**optics approach fot advanced semiconductor**
**lasers"**

(73) Proprietor : **AT & T Corp.**
**32 Avenue of the Americas**
**New York, NY 10013-2412 (US)**

(72) Inventor : **Koch, Thomas L.**
**12 Donner Street**
**Holmdel, New Jersey 07733 (US)**
Inventor : **Koren, Uziel**
**26 Forrest Avenue**
**Fair Haven, New Jersey 07704 (US)**

(74) Representative : **Watts, Christopher Malcolm**
**Kelway, Dr. et al**
**AT&T (UK) LTD.**
**AT&T Intellectual Property Division**
**5 Mornington Road**
**Woodford Green Essex IG8 OTU (GB)**

## Description

## Technical Field

This invention is related to semiconductor devices and, more particularly, to devices incorporating optical waveguide structures.

## Background of the Invention

Efficient transfer of lightwave signals from one waveguide to another is important to the development of optical systems and circuits. Lightwave communication systems require communication, at a minimum, between the transport medium such as optical fiber and waveguide devices such as lasers, couplers, switches and detectors. By comparison, propagating modes of the lightwave signals in the transport medium are significantly larger than in the waveguide devices. For example, signal mode optical fibers propagate lightwave signals having a fundamental mode of approximately 6-10μm width whereas waveguide devices such as single frequency semiconductor lasers support lightwave signals having a fundamental mode width less than approximately 1 μm.

Tapers have been developed to control the mode size of the guided lightwave signals and, thereby, provide efficient coupling between optical waveguide devices and optical fibers. Tapers have been realized in two forms: a fiber taper which, as the name suggests, is based solely in the optical fiber and a tapered waveguide which is based solely in the device structure. In both forms, the taper increases or decreases along the direction of propagation for the lightwave signals.

Tapered waveguides, whether based in semiconductor material or electrooptic material, have been formed by epitaxial growth techniques or by special etching techniques such as photoelectrochemical etching or selective chemical etching. In addition, tapers have been formed in either the horizontal or the vertical direction, transverse to the propagation direction. For example, see Appl. Phys. Lett., 26(6), pp. 337-40(1975), U. S. Patent 3,993,963, and U. S. Patent 3,978,426. while individual attempts to create tapered waveguides have succeeded, it has been found that the techniques employed lack sufficient controllability for making identically reproducible tapered waveguides from one device to the next.

## Summary of the Invention

The present invention is defined by claims 1 and 10, wherein adiabatic mode control and a high degree of structural reproducibility are afforded by a tapered semiconductor waveguide structure wherein individual semiconductor guiding layers are interleaved with corresponding individual stop-etch layers and each successive guiding layer extends further along the propagation axis of the waveguide than the guiding layer immediately adjacent thereabove to create a staircase-like core or guiding structure. Cladding regions of appropriate semiconductor material having a lower index of refraction than the tapered structure may be added to completely surround the tapered structure. The profile of the tapered guiding structure is realizable as any desired shape such as linear, parabolic, exponential or the like.

In another embodiment, additional layers of higher index of refraction semiconductor material may be included in the cladding region to permit additional beam shaping of the expanded spatial mode propagating along the tapered waveguide.

In additional embodiments, the tapered semiconductor waveguide is included as an intra-cavity element for semiconductor lasers to provide beam expansion at an end facet, for example.

Photolithographic masks defining successively larger exposed areas are aligned, deposited over the waveguide structure, and then removed following each etching step. Material selective etching techniques are employed to remove exposed (unmasked) portions of guiding layers. In sequence, the exposed, formerly underlying portions of the stop-etch layers are then removed using material selective etching. Iteration of the above process steps permits a tapered waveguide structure to be defined.

## Brief Description of the Drawing

A more complete understanding of the invention may be obtained by reading the following description of specific illustrative embodiments of the invention in conjunction with the appended drawing in which:

FIGs. 1 through 4 show successive processing steps for making a tapered semiconductor waveguide (shown in cross-sectioned view) in accordance with the principles of the invention;

FIG. 5 is a cross-sectional view of an exemplary tapered semiconductor waveguide including beam shaping elements; and

FIGs. 6 and 7 show exemplary lightwave signals input to and output from the tapered semiconductor waveguides shown in FIGs. 4 and 5, respectively.

It should be noted that the elements and embodiments shown in the various FIGs. have not been drawn to scale. They are merely illustrative of aspects of the present invention. As a result, the drawing is intended to be construed for purposes of explication and not for the purpose of limitation.

## Detailed Description

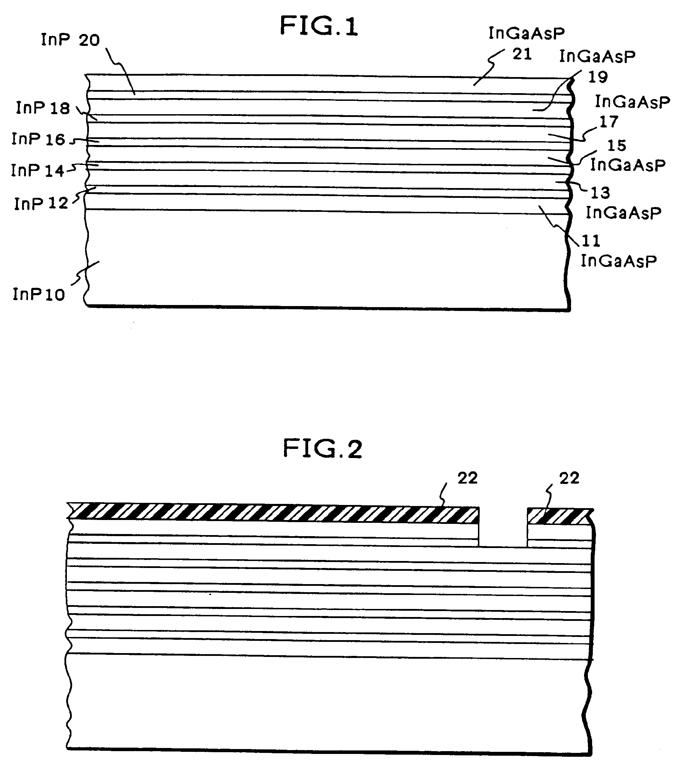

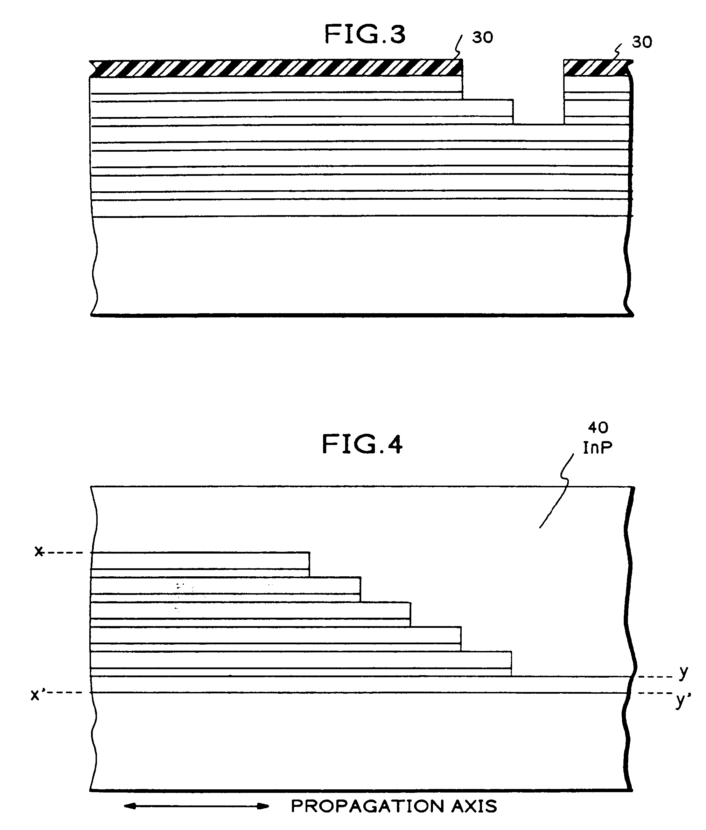

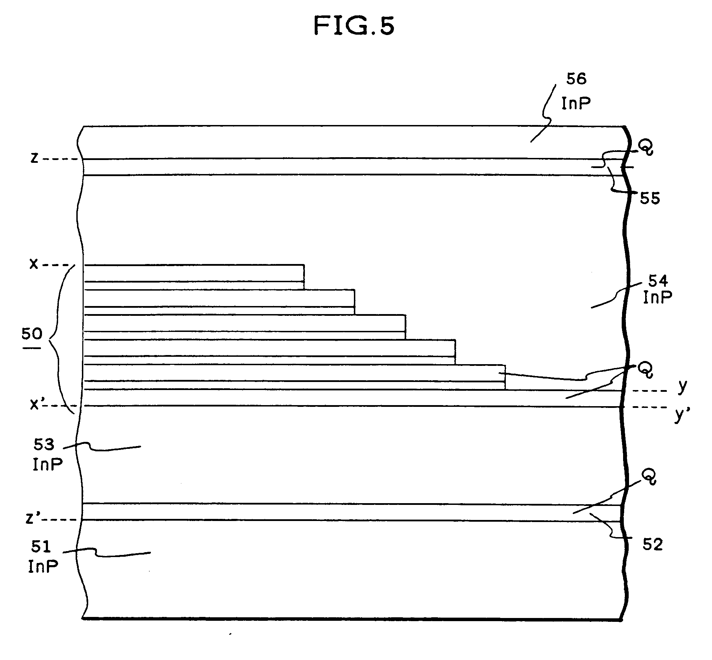

The semiconductor heterostructure shown in FIG. 1 may be fabricated by standard epitaxial processing techniques such as molecular beam epitaxy, vapor phase epitaxy, and metal organic chemical vapor deposition. Fabrication techniques including semiconductor layer growth, impurity doping, photolithography and any contact metallization to realize exemplary devices shown in FIGs. 4 and 5, in accordance with the principles of the invention described above, are believed to be well known to those persons of ordinary skill in the art. For a complete overview and discussion of the techniques, see AT&T Technical Journal, Vol. 68, No. 1 (January/February 1989).

It is understood that, while the material system InGaAsP/InP is described below for fabricating the tapered semiconductor waveguide device, other material combinations may be selected from other semiconductor Group III-V systems such as GaAs/AlGaAs, GaAs/AlAs, InGaAs/InAlAs, InGaAs/InGaAlAs, and GaAsSb/GaAlAsSb. In these semiconductor systems, the layers may be lattice-matched to suitable GaAs or InP substrates. Mismatching is also contemplated wherein strained layers are grown over the substrate material. Finally, extension of the device structures is also contemplated to semiconductor compounds in Group II-VI.

Since the practice of the present invention involves the formation of a staircase-like profile through a series of layers, it is necessary to have a starting workpiece including the necessary series of layers. An exemplary series of layers having the desirably necessary attributes comprises a plurality of guiding layers and a corresponding plurality of stop-etch layers interleaved with the plurality of guiding layers as shown in FIG. 1. Standard epitaxial growth techniques commonly known to those persons of ordinary skill in the art were employed to form the semiconductor heterostructure in FIG. 1.

As shown in FIG. 1, a lower cladding layer 10 supports the guiding layer/stop-etch layer interleaved structure. Layer 10 comprises InP and, in some applications, may lie between the guiding layer/stop-etch layer interleaved structure and a substrate. In other applications, layer 10 may act also as the substrate for the waveguide.

Above layer 10 are grown the following layers in succession: guiding layer 11, stop-etch layer 12, guiding layer 13, stop-etch layer 14, guiding layer 15, stop-etch layer 16, guiding layer 17, stop-etch layer 18, guiding layer 19, stop-etch layer 20, and guiding layer 21. The guiding layers comprise semiconductor material having a higher index of refraction than the index of refraction for the material forming a cladding for the waveguide, whether semiconductor, air or otherwise. In the present example, quaternary material comprising $In_{1-y}Ga_yAs_xP_{1-x}$ is employed for guiding layers, wherein the alloy composition ratios x and y are selected to produce a particular lattice constant and a particular wavelength or energy bandgap for the heterostructure. For a description of techniques for choosing x and y, see R. Moon et al., J. Electron.

Materials, Vol. 3, p. 635 et seq. (1974). Thickness of individual guiding layers is taken into consideration when determining the shape of the tapered waveguide and the amount of spatial mode confinement desired at each end and along the length of the tapered waveguide.

The stop-etch layers comprise semiconductor material which have a substantially reduced etch rate for any etchant or etching technique which is utilized in the processing of the guiding layers. In this example, InP stop-etch layers have a lower etch rate in the material selective etchants which are used to remove exposed portions of InGaAsP guiding layers. By employing these techniques, it is possible to fabricate tapered waveguides in which each stop-etch layer may possibly have a thickness measured from heterointerface to heterointerface which is sufficiently small to avoid significantly perturbing characteristics of the optical signal guided by the guiding layers. However, the use of stop-etch layers which perturb characteristics of the optical signal is contemplated provided that the overall effect does not significantly impair operation of the tapered waveguide.

Realization of tapering occurs by sequential mask/etching which begins by covering the uppermost guiding layer shown as layer 21 with photolithographic mask 22 as shown in FIG. 2. Photoresist masks such as Shipley or AZ or the like are suitable for use as mask 22. Deposition techniques such as CVD or the like are also suitable for depositing the mask. When employing the latter technique, silicon nitride or silicon oxide layers are commonly used for masking. Mask 22 includes an opening to define an exposed area of layer 21.

After the mask is in place, a material selective etchant is placed in contact with guiding layer 21 to remove the portion thereof exposed by the mask. Several wet chemical etchants have been shown to be suitable for selectively removing quaternary semiconductor material such as exists in the heterostructure in FIG. 2. Examples of several selective etchants include: a solution of $H_2SO_4$:$H_2O_2$:$H_2O$ in ratios such as 3:1:1 and 10:1:1; or AB etchant wherein the A solution is approximately 40 ml. $H_2O$ + 0.3g. $AgNO_3$ +40 ml. HF and the B solution is approximately 40 g. $CrO_3$ + 40 ml. $H_2O$; or a solution of KOH:$K_3Fe(CN)_{6:H_2}O$. Etching time varies according to the thickness of the particular quaternary layer, temperature, and alloy composition ratios for the layer. Usually etching is halted by rinsing the etchant away with, for example, deionized water. Mask 22 may be removed at this point or after the removal of the exposed portion of stop-etch layer 20.

After the exposed portion of layer 21 is removed, the vertical edges of layer 21 are suitable for masking the exposed portion of stop-etch layer 20. Etchants such as HCl or HCl:$H_3PO_4$ (e. g., 2:1) are useful in etching InP stop-etch layers. In general, etchants such as HCl continue to react with InP until a particular crystallographic plane is exposed. As such, rinsing may or may not be required to halt the etching of layer 20.

To continue the tapering process, it is necessary to form photolithographic mask 30 on layer 21 as shown in FIG. 3. Mask 30 is substantially aligned on one side with the end of the former opening for mask 22, now removed. The opening in mask 30 exposes a larger portion of layer 21 (extending to the left of the removed portion). As a result, portions of both guiding layers 21 and 19 are exposed for subsequent etching. The process described above is useful for developing a conceptual understanding of the tapering process. In actual wafer production, chips are flip-flopped so that a descending taper from one chip flows into an ascending taper for another chip. Then, a cleave would be made between the descending and ascending tapers. Also, it should be noted that the tapering process is performed generally before lateral processing occurs for defining waveguide vertical sidewalls and the like.

Material selective etchants are applied to the exposed portions of the guiding layers to expose the underlying stop-etch layer, layers 20 and 18. This etching step is substantially halted by the stop-etch layers. If necessary, the etching step may be completely halted by rinsing to remove the etchant. Other material selective etchants are then applied to now exposed portions of stop-etch layers 20 and 18 to remove those portions. An exemplary resulting structure from the sequential mask/etch procedure is shown in FIG. 3.

This procedure is carried on with additional mask/etch steps wherein each photolithographic mask defines an opening which is larger, by a predetermined amount, than the opening defined by the previous masks. For the initial structure shown in FIG. 1, the sequential mash procedure results after five iterations with a staircase-like tapered profile as shown in FIG. 4.

As shown in FIG. 4, an additional cladding layer 40 is epitaxially grown over the exposed tapered waveguide. Layer 40 is selected from materials having a lower refractive index than that of the tapered structure. While the cross-sectional view shows cladding for the guiding layers from above and below the heterostructure, it is contemplated that lateral or transverse cladding regions be formed around the tapered heterostructure.

Demarcations x - x′ and y - y′ denote the reference points at the outermost guiding layers at each end of the taper. The corresponding reference points are depicted in directions perpendicular to the propagation axis along which optical signals generally propagate.

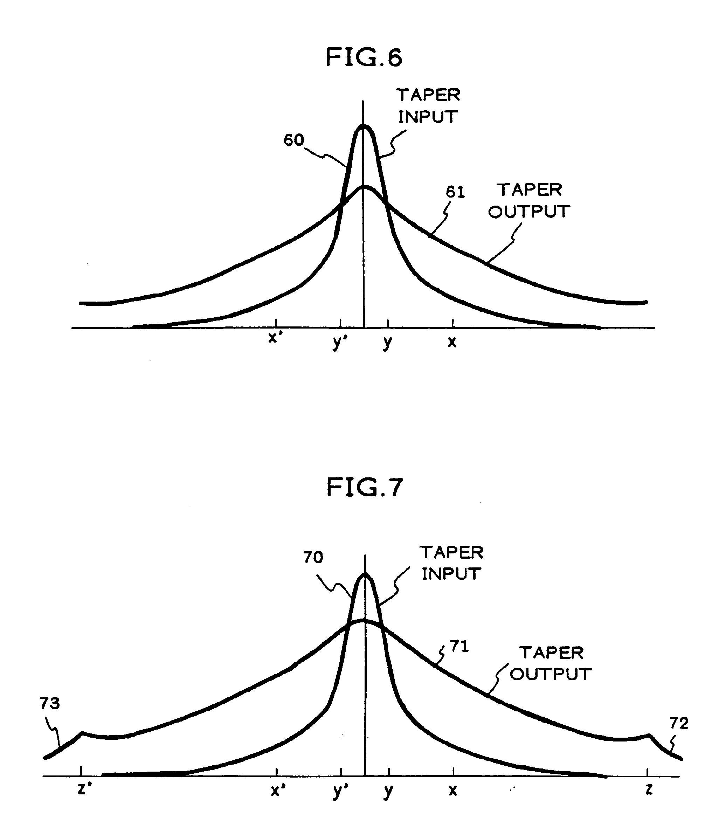

These reference points are useful in comparing the spatial modes at various locations along the taper. As shown in FIG. 6, the optical signal having spatial mode 60 is input to the tapered waveguide and is confined substantially between the reference points x - x′ of guiding layers 11 through 21. The central modes of the signals have been shifted to permit a better appreciation of the taper operation. Note that the signals have not been drawn to scale. When the optical signal traverses the tapered waveguide, the optical signal undergoes adiabatic beam expansion with increasing optical power coupling into the cladding region around the taper. Upon reaching the taper output, the optical signal has a mode as depicted by spatial mode 61 which is significantly larger than the beam at the taper input and a still guided by the guiding layer whose reference points are y - y′ (e. g., layer 11). Accordingly, the spatial mode of the optical signal traversing the taper is forced to make an adiabatic transition from a tightly controlled mode such as output by a laser to a significantly larger mode which is excellent for fiber coupling, for example.

By expanding the mode size, it is possible to control and reduce the beam divergence for optical signals output by the tapered waveguide. This is possible because large fundamental spatial mode output from the tapered waveguide exhibits a substantially flat phase front. Beam divergence control has been observed from far field measurements taken on a waveguide device similar to the one described above wherein the tapered waveguide decreased from approximately 3000Å (x - x′) to approximately 500Å (y - y′) over a length exceeding 100μm measured along the propagation axis. Full half power angles for the far field radiation patterns were observed between 10° and 12° for both vertical and horizontal transverse axes.

In an exemplary embodiment and application, the tapered waveguide is employed inside a laser cavity having a multiple quantum well active layer structure along a portion of the resonator cavity length before the tapered waveguide. The multiple quantum well layer structure includes an active stack of wells having a photoluminescence wavelength $\lambda_p \approx 1.5\mu m$. The multiple quantum well active stack comprises four quantum wells having a total thickness of approximately 800Å utilizing InGaAs and InGaAsP (1.3μm) as the well and barrier materials, respectively. The active layer structure (not shown) is situated on top of the taper heterostructure of FIG. 1, and is separated from layer 21 by an InP stop-etch layer (also, not shown) having a thickness of approximately 200Å. The active layer structure and the stop-etch layer immediately thereunder are removed to leave a passive transparent waveguide heterostructure along a predetermined portion of the laser cavity, which is then transformed into the tapered waveguide in accordance with the principles described herein. Stop-etch layer 20 and the remaining stop-etch layers were approximately 200Å thick. Guiding layers 21 through 11 comprises InGaAsP (1.3μm). Guiding layer 21 having a thickness of approximately 1025Å is extended beyond the etched end of the active layer stack and its underlying stop-etch layer (both not shown) by approximately 20μm. Guiding layer 19 having a thickness of approximately 700Å is extended beyond the etched end of layers 21 and 20 by approximately 20μm. Guiding layer 17 having a thickness of approximately 425Å is extended beyond the etched end of layers 19 and 18 by approximately 25μm. Guiding layer 15 having a thickness of approximately 300Å is extended beyond the etched end of layers 17 and 16 by approximately 30μm. Guiding layer 13 having a thickness of approximately 250Å is extended beyond the etched end of layers 15 and 14 by approximately 40μm. Guiding layer 11 having a thickness of approximately 500Å is extended beyond the etched end of layers 13 and 12 as the output guiding layer of the tapered waveguide device. While the tapered waveguide described above has a somewhat non-linear tapered profile, linear, quadratic, logarithmic, exponential or any other desirable profiles are contemplated and achievable by properly varying the length, or the thickness, or the length and thickness of the various guiding layers included in the tapered structure. It should be clear to those skilled in the art that the extension of one guiding layer past the etched end of the prior layer is preferably selected to be longer than several optical wavelengths to insure proper adiabatic changes in the waveguide mode profile. Typically, these extensions are on the order of several microns.

Additional beam control or beam shaping is afforded by including one or more guiding layers in the cladding region around the tapered structure. Such additional guiding layers tend to contain the optical power to the vicinity of the tapered structure, and can lead to more desirable beam profiles. Asymmetric and symmetric displacements of the additional guiding layers are contemplated for beam control and shaping.

One exemplary embodiment of a beam control and shaping element combined with the tapered waveguide is shown in FIG. 5. Tapered waveguide structure 50 comprising interleaved guiding and stop-etch layers is surrounded by a lower refractive index cladding region including cladding layers 51, 53, 54 and 56. Within the cladding region are disposed higher refractive index guiding layers 52 and 55 for controlling the shape of the spatial mode for the optical signal output from the tapered waveguide.

FIG. 7 shows the effects of beam control and shaping in accordance with the structure from FIG. 5. The central modes of the signals have been shifted to permit a better appreciation of the taper operation. Note that the signals have not been drawn to scale but should suffice for this analysis. In this example, additional optical signal power has been guided to the taper output by the inclusion of beam shaping via guiding layers 52 and 55 in the cladding region. In comparison to taper output signal 61, taper output signal 71 includes more output power between reference points z - z′ and has some additional shaping in the mode at z′ (location 73) and z (location 72) as shown.

Several benefits obtain from utilizing the tapered waveguide structure described above. The processing is standard and longitudinal in nature. Moreover, it is compatible with present technology employed in fabricating III-V lasers and photonic integrated circuits. As a result, the waveguide is integrable with photonic devices and exhibits high reproducibility. Critical alignment has been substantially reduced by the large taper optical output, so that the tapered waveguide device will permit greater packaging tolerances. The taper design is usually established to achieve equal loss at each step interface from guiding layer to adjacent guiding layer.

## Claims

1. A method for etching a multilayer semiconductor heterostructure body to form a tapered semiconductor waveguide device tapered in the propagation direction of the light signal, said multilayer semiconductor heterostructure body including guiding layers (11, 13, 15, 17, 19, 21) and stop-etch layers (12, 14, 16, 18, 20) interleaved with each other, the method comprising the steps of:
masking the uppermost guiding layer (21) to define an opening so as to expose a predetermined area of said guiding layer (21);
a first etching step performed by contacting the surface of said predetermined exposed guiding layer portion with a first material selective chemical etchant for a time period sufficient to expose a corresponding predetermined portion of the stop-etch layer beneath;
a second etching step performed by contacting the surface of said predetermined exposed stop-etch layer portion with a second material selective chemical etchant for a time period sufficient to expose a corresponding predetermined portion of the guiding layer beneath;
iterating in sequence the masking step, the first etching step followed by the second etching step wherein each masking step defines an opening which is larger than the opening defined by the previous masks, so that the predetermined exposed layer portions during a given iteration are longer than and include at least the predetermined exposed layer portions for previous iterations so that a staircase-like tapered waveguide profile is formed.

2. The method defined in claim 1 wherein the multilayer semiconductor heterostructure body comprises semiconductor material consisting of compositions selected from Groups III and V and Groups II and VI.

3. The method defined in claim 2 wherein the guiding layers comprise InGaAsP and the stop-etch layers comprise InP, and wherein the first material selective etchant comprises $H_2SO_4:H_2O_2:H_2O$ and the second material selective etchant comprises HCl.

4. The method defined in claim 3 wherein the second material selective etchant comprises $HCl:H_3PO_4$.

5. The method defined in claim 1 wherein each guiding layer extends along a predetermined axis of said multilayer semiconductor heterostructure body sufficiently far for said guiding layers to exhibit a staircase-like profile selected from the group consisting of linear, parabolic and exponential profiles.

6. The method defined in claim 2 wherein the guiding layers comprise InGaAsP and the stop-etch layers comprise InP, and wherein the first material selective etchant comprises AB etchant solution and the second material selective etchant comprises HCl.

7. The method defined in claim 6 wherein the second material selective etchant comprises $HCl:H_3PO_4$.

8. The method defined in claim 2 wherein the guiding layers comprise InGaAsP and the stop-etch layers comprise InP, and wherein the first material selective etchant comprises $KOH:K_3Fe(CN)_6:H_2O$ and the second material selective etchant comprises HCl.

9. The method defined in claim 8 wherein the second material selective etchant comprises $HCl:H_3PO_4$.

10. A tapered waveguide having a propagation axis and a reference plane defined normal to said propagation axis, wherein the tapered waveguide comprises a plurality of guiding layers (11, 13, 15, 17, 19, 21) including a first semiconductor material, and a plurality of stop-etch layers (12, 14, 16, 18, 20) including a second semiconductor material, said stop-etch layers arranged alternately with said guiding layers, and each guiding layer arranged to extend from said reference plane along said propagation axis further than said guiding layer immediately adjacent thereabove, so as to form a staircase-like tapered waveguide profile.

11. The tapered waveguide defined in claim 10 further including a cladding region (51, 53, 54, 56) substantially surrounding exterior surfaces of said pluralities of guiding and stop-etch layers, said cladding region comprising third semiconductor material, said first semiconductor material having an index of refraction which is greater than an index of refraction for said third semiconductor material.

12. The tapered waveguide defined in claim 11 wherein said first, second and third semiconductor materials are selected from the group consisting of Group III-V compositions and Group II-VI compositions.

13. The tapered waveguide defined in claim 11 wherein said first semiconductor material includes InGaAsP, and said second and third semiconductor materials include InP.

14. The tapered waveguide defined in any of claims 11 to 13 wherein said cladding region further including means (52, 55) for controlling the beam shape of lightwave signals propagating along said tapered waveguide.

15. The tapered waveguide defined in claim 14 wherein said controlling means comprises at least a first beam control layer (52) including a fourth semiconductor material having an index of refraction greater than said index of refraction for said third semiconductor material, said first beam control layer being disposed parallel to said plurality of guiding layers.

16. The tapered waveguide defined in claim 15 wherein said fourth semiconductor material is selected from the group consisting of Group III-V compositions and Group II-VI compositions.

17. The tapered waveguide defined in claim 15 or claim 16 wherein said controlling means further comprises a second beam control layer (55) including a fifth semiconductor material having an index of refraction greater than said index of refraction for said third semiconductor material, said second beam control layer being disposed parallel to said plurality of guiding layers and on an opposite side of said plurality of guiding layers from said first beam control layer.

18. The tapered waveguide defined in claim 17 wherein said fifth semiconductor material is selected from the group consisting of Group III-V compositions and Group II-VI compositions.

19. The tapered waveguide defined in any of claims 10 to 18 wherein each guiding layer of said plurality extends along the propagation axis sufficiently far for said plurality of guiding layers to exhibit a staircase-like profile selected from the group consisting of linear, parabolic and exponential profiles.

**Patentansprüche**

1. Verfahren zum Ätzen eines Mehrlagen-Halbleiter-Heterostrukturkörpers zum Ausbilden einer sich verjüngenden Halbleiter-Wellenleitereinrichtung, die sich in der Ausbreitungsrichtung des Lichtsignals verjüngt, wobei der Mehrlagen-Halbleiter-Heterostrukturkörper Führungsschichten (11, 13, 15, 17, 19, 21) und Ätzstopschichten (12, 14, 16, 18, 20) ineinander verschachtelt enthält, wobei das Verfahren die Schritte umfaßt: Maskieren der obersten Führungsschicht 21 zum Definieren einer Öffnung, um derart einen vorbestimmten Bereich der Führungsschicht 21 freizulegen, einen ersten Ätzschritt, der durch Inkontakttreten des vorbestimmten freigelegten Führungsschichtanteils mit einem ersten materialselektiven Ätzmittel während einer Zeitdauer, die ausreichend ist, einen entsprechenden vorbestimmten Anteil der darunterliegenden Ätzstopschicht freizulegen, durchgeführt wird, einen zweiten Ätzschritt, der durch Inkontaktbringen der Oberfläche des vorbestimmten freigelegten Ätzstopschichtanteils mit einem zweiten materialselektiven chemischen Ätzmittel während einer Zeitdauer, die ausreicht, einen entsprechenden vorbestimmten Anteil der darunterliegenden Führungsschicht freizulegen, durchgeführt wird, Iterieren des Maskierungsschrittes, des ersten Ätzschrittes gefolgt von dem zweiten Ätzschritt in Folge, wobei jeder Maskierungsschritt eine Öffnung definiert, die größer ist als die Öffnung, die durch die vorhergehende Maske definiert wurde, so daß die vorbestimmten freigelegten Schichtanteile während einer gegebenen Iteration länger sind als die vorbestimmten freigelegten Schichtanteile von vorhergehenden Iterationen und wenigstens den vorbestimmten Anteil der freigelegten Schichtanteile von vorhergehenden Iterationen so umfassen, daß ein stufenförmiges sich verjüngendes Wellenleiterprofil ausgebildet wird.

2. Verfahren nach Anspruch 1, in welchem der Mehrlagen-Halbleiter-Heterostrukturkörper Halbleitermaterial umfaßt, das aus Zusammensetzungen besteht, die aus den Gruppen III und V und den Gruppen II und VI ausgewählt sind.

3. Verfahren nach Anspruch 2, in welchem die Führungsschichten InGaAsP und die Ätzstopschichten InP umfassen und in welchem das erste materialselektive Ätzmittel $H_2SO_4:H_2O_2:H_2O$ umfaßt und das zweite materialselektive Ätzmittel HCl umfaßt.

4. Verfahren nach Anspruch 3, in welchem das zweite materialselektive Ätzmittel $HCl:H_3PO_4$ umfaßt.

5. Verfahren nach Anspruch 1, in welchem sich jede Führungsschicht entlang einer vorbestimmten Achse des Mehrlagen-Halbleiter-Heterostrukturkörpers ausreichend weit erstreckt, daß so die Führungsschichten ein stufenförmiges Profil aufweisen, das ausgewählt ist aus der Gruppe, die lineare, parabolische und exponentielle Profile umfaßt.

6. Verfahren nach Anspruch 2, in welchem die Führungsschichten InGaAsP umfassen und die Ätzstopschichten InP umfassen und in welchem das erste materialselektive Ätzmittel eine AB-Ätzmittellösung umfaßt und das zweite materialselektive Ätzmittel HCl umfaßt.

7. Verfahren nach Anspruch 6, in welchem das zweite materialselektive Ätzmittel $HCL:H_3PO_4$ umfaßt.

8. Verfahren nach Anspruch 2, in welchem die Führungsschichten InGaAsP umfassen und die Ätzstopschichten InP umfassen und in welchem das erste materialselektive Ätzmittel $KOH:K_3Fe(CN)_6:H_2O$ umfaßt und das zweite materialselektive Ätzmittel HCl umfaßt.

9. Verfahren nach Anspruch 8, in welchem das zweite materialselektive Ätzmittel $HCl:H_3PO_4$ umfaßt.

10. Sich verjüngender Wellenleiter mit einer Ausbreitungsrichtung und einer Bezugsebene, die in Normalenrichtung zur Ausbreitungsrichtung definiert ist, in welchem der sich verjüngende Wellenleiter eine Vielzahl von Führungsschichten (11, 13, 15, 17, 19, 21) umfaßt, die ein erstes Halbleitermaterial enthalten, und eine Vielzahl von Ätzstopschichten (12, 14, 16, 18, 20) umfaßt, die ein zweites Halbleitermaterial enthalten, wobei die Ätzstopschichten abwechselnd zu den Führungsschichten angeordnet sind und jede Führungsschicht sich von der Bezugsebene entlang der Ausbreitungsrichtung weiter als die unmittelbar darüber gelegene benachbarte Führungsschicht erstreckt, um so ein stufenförmiges sich verjüngendes Wellenleiterprofil auszubilden.

11. Sich verjüngender Wellenleiter nach Anspruch 10, ferner umfassend einen Ummantelungsbereich (51, 53, 54, 56), der im wesentlichen die äußeren Oberflächen der Vielzahl von Führungs- und Ätzstopschichten umgibt, wobei der Ummantelungsbereich ein drittes Halbleitermaterial enthält, das erste Halbleitermaterial einen Brechungsindex hat, der höher als der Brechungsindex des dritten Halbleitermaterials ist.

12. Sich verjüngender Wellenleiter nach Anspruch 11, in welchem das erste, das zweite und das dritte Halbleitermaterial aus der Gruppe ausgewählt sind, die aus Gruppe-III-V-Zusammensetzungen und aus Gruppe-II-VI-Zusammensetzungen besteht.

13. Sich verjüngender Wellenleiter nach Anspruch 11, in welchem das erste Halbleitermaterial InGaAsP umfaßt und das zweite und dritte Halbleitermaterial InP umfaßt.

14. Sich verjüngender Wellenleiter nach einem der Ansprüche 11 bis 13, in welchem der Ummantelungsbereich ferner eine Einrichtung (52, 55) zum Steuern der Strahlform von Lichtwellensignalen, die sich entlang des sich verjüngenden Wellenleiters ausbreiten, umfaßt.

15. Sich verjüngender Wellenleiter nach Anspruch 14, in welchem die Steuereinrichtung wenigstens eine erste Strahlsteuerschicht 52 umfaßt, die ein viertes Halbleitermaterial mit einem Brechungsindex, der höher ist als der Brechungsindex des dritten Halbleitermaterials, enthält, wobei die erste Strahlsteuerschicht parallel zur Vielzahl von Führungsschichten angeordnet ist.

16. Sich verjüngender Wellenleiter nach Anspruch 15, in welchem das vierte Halbleitermaterial aus der Gruppe ausgewählt ist, die aus den Gruppe-III-V-Zusammensetzungen und den Gruppe-II-VI-Zusammensetzungen besteht.

17. Sich verjüngender Wellenleiter nach Anspruch 15 oder 16, in welchem die Steuereinrichtung ferner eine zweite Strahlsteuerschicht (55) umfaßt, die ein fünftes Halbleitermaterial mit einem Brechungsindex, der höher als der Brechungsindex des dritten Halbleitermaterials ist, enthält, wobei die zweite Strahlsteuerschicht parallel zu der Vielzahl von Führungsschichten und auf einer der ersten Strahlsteuerschicht gegenüberliegenden Seite der Vielzahl von Führungsschichten angeordnet ist.

18. Sich verjüngender Wellenleiter nach Anspruch 17, in welchem das fünfte Halbleitermaterial aus der Gruppe ausgewählt ist, die aus den Gruppe-III-V-Zusammensetzungen und den Gruppe-II-VI-Zusammensetzungen besteht.

19. Sich verjüngender Wellenleiter nach einem der Ansprüche 10 bis 18, in welchem sich jede Führungsschicht von der besagten Vielzahl entlang der Ausbreitungsrichtung ausreichend weit von der Vielzahl von Führungsschichten entfernt erstreckt, um ein stufenförmiges Profil auszubilden, das aus der Gruppe ausgewählt ist, die lineare, parabolische und exponentielle Profile umfaßt.

## Revendications

1. Un procédé pour graver un article consistant en une hétérostructure à semiconducteurs multicouche, pour former un dispositif à guide d'ondes à semiconducteurs à variation progressive de section, dont la section varie progressivement dans la direction du signal lumineux, cet article consistant en une hétérostructure à semiconducteurs multicouche comprenant des couches de guidage (11, 13, 15, 17, 19, 21) et des couches d'arrêt de gravure (12, 14, 16, 18, 20) mutuellement intrelacées, le procédé comprenant les étapes suivantes :

on masque la couche de guidage supérieure (21) pour définir une ouverture de façon à mettre à nu une partie prédéterminée de la couche de guidage (21);

une première étape de gravure effectuée en mettant en contact la surface de la partie de couche de guidage à nu prédéterminée avec un premier agent de gravure chimique sélectif vis-à-vis des matériaux, pendant une durée suffisante pour mettre à nu une partie prédéterminée correspondante de la couche d'arrêt de gravure se trouvant au-dessous;

une seconde étape de gravure effectuée en mettant en contact la surface de la partie de couche d'arrêt de gravure à nu prédéterminée avec un second agent de gravure chimique sélectif vis-à-vis des matériaux, pendant une durée suffisante pour mettre à nu une partie prédéterminée correspondante de la couche de guidage se trouvant au-dessous;

on répète séquentiellement l'étape de masquage, et la première étape de gravure suivie par la seconde étape de gravure, dans des conditions dans lesquelles chaque étape de masquage définit une ouverture qui est plus grande que l'ouverture définie par les masques précédents, de façon que les parties de couche à nu prédéterminées pendant une répétition donnée soient plus longues que les parties de couche à nu prédéterminées pour des répétitions précédentes, et contiennent au moins celles-ci, de manière à former un profil de guide d'ondes à variation progressive de section, en forme d'escalier.

2. Le procédé défini dans la revendication 1, dans lequel l'article consistant en une hétérostructure à semiconducteurs multicouche comprend un matériau semiconducteur formé par des compositions sélectionnées parmi les Groupes III et V et les Groupes II et VI.

3. Le procédé défini dans la revendication 2, dans lequel les couches de guidage consistent en InGaAsP et les couches d'arrêt de gravure consistent en InP, et dans lequel le premier agent de gravure sélectif vis-à-vis des matériaux consiste en $H_2SO_4:H_2O_2:H_2O$ et le second agent de gravure sélectif vis-à-vis des matériaux consiste en HCl.

4. Le procédé défini dans la revendication 3, dans lequel le second agent de gravure sélectif vis-à-vis des matériaux consiste en $HCl:H_3PO_4$.

5. Le procédé défini dans la revendication 1, dans lequel chaque couche de guidage s'étend le long d'un axe prédéterminé de l'article consistant en une hétéro-structure à semiconducteurs multicouche, suffisamment loin pour que les couches de guidage présentent un profil en escalier sélectionné dans le groupe comprenant des profils linéaires, paraboliques et exponentiels.

6. Le procédé défini dans la revendication 2, dans lequel les couches de guidage consistent en InGaAsP et les couches d'arrêt de gravure consistent en InP, et dans lequel le premier agent de gravure sélectif vis-à-vis des matériaux consiste en une solution d'agent de gravure AB et le second agent de gravure sélectif vis-à-vis des matériaux consiste en HCl.

7. Le procédé défini dans la revendication 6, dans lequel le second agent de gravure sélectif vis-à-vis des matériaux consiste en $HCl:H_3PO_4$.

8. Le procédé défini dans la revendication 2, dans lequel les couches de guidage consistent en InGaAsP et les couches d'arrêt de gravure consistent en InP, et dans lequel le premier agent de gravure sélectif vis-à-vis des matériaux consiste en $KOH:K_3Fe(CN)_6:H_2O$, et le second agent de gravure sélectif vis-à-vis des matériaux consiste en HCl.

9. Le procédé défini dans la revendication 8, dans lequel le second agent de gravure sélectif vis-à-vis des matériaux consiste en $HCl:H_3PO_4$.

10. Un guide d'ondes à variation progressive de section ayant un axe de propagation et un plan de référence défini, normal à l'axe de propagation, dans lequel le guide d'ondes à variation progressive de section comprend un ensemble de couches de guidage (11, 13, 15, 17, 19, 21) comprenant un premier matériau semiconducteur, et un ensemble de couches d'arrêt de gravure (12, 14, 16, 18, 20) comprenant un second matériau semiconducteur, les couches d'arrêt de gravure étant disposées en alternance avec les couches de guidage, et chaque couche de guidage étant disposée de façon à s'étendre à partir du plan de référence, le long de l'axe de propagation, plus loin que la couche de guidage immédiatement adjacente et située au-dessus, de façon à former un profil de guide d'ondes à variation progressive de section ayant une forme en escalier.

11. Le guide d'ondes à variation progressive de section défini dans la revendication 10, comprenant en outre une région de gaine (51, 53, 54, 56) qui entoure pratiquement des surfaces extérieures de l'ensemble de couches de guidage et d'arrêt de gravure, cette région de gaine comprenant un troisième matériau semiconducteur, et le premier matériau semiconducteur ayant un indice de réfraction qui est supérieur à l'indice de réfraction du troisième matériau semiconducteur.

12. Le guide d'ondes à variation progressive de section défini dans la revendication 11, dans lequel les premier, second et troisième matériaux semiconducteurs sont sélectionnés dans le groupe qui comprend des compositions du Groupe III-V et des compositions du Groupe II-VI.

13. Le guide d'ondes à variation progressive de section défini dans la revendication 11, dans lequel le premier matériau semiconducteur consiste en InGaAsP et les second et troisième matériaux semiconducteurs consistent en InP.

14. Le guide d'ondes à variation progressive de section défini dans l'une quelconque des revendications 11 à 13, dans lequel la région de gaine comprend en outre des moyens (52, 55) pour maîtriser la forme du faisceau de signaux d'ondes lumineuses se propageant le long du guide d'ondes à variation progressive de section.

15. Le guide d'ondes à variation progressive de section défini dans la revendication 14, dans lequel les moyens de maîtrise comprennent au moins une première couche de maîtrise de faisceau (52) qui comprend un quatrième matériau semiconducteur ayant un indice de réfraction supérieur à l'indice de réfraction du troisième matériau semiconducteur, cette première couche de maîtrise de faisceau étant disposée parallèlement à l'ensemble de couches de guidage.

16. Le guide d'ondes à variation progressive de section défini dans la revendication 15, dans lequel le quatrième matériau semiconducteur est sélectionné dans le groupe qui comprend des compositions du Groupe III-V et des compositions du Groupe II-VI.

17. Le guide d'ondes à variation progressive de section défini dans la revendication 15 ou 16, dans lequel les moyens de maîtrise comprennent en outre une seconde couche de maîtrise de faisceau (55) qui comprend un cinquième matériau semiconducteur ayant un indice de réfraction supérieur à l'indice de réfraction du troisième matériau semiconducteur, cette seconde couche de maîtrise de faisceau étant disposée parallèlement à l'ensemble de couches de guidage, et d'un côté de l'ensemble de couches de guidage qui est opposé à celui de la première couche de maîtrise de faisceau.

18. Le guide d'ondes à variation progressive de section défini dans la revendication 17, dans lequel le cinquième matériau semiconducteur est sélectionné dans le groupe qui comprend des compositions du Groupe III-V et des compositions du groupe II-VI.

19. Le guide d'ondes à variation progressive de section défini dans l'une quelconque des revendications 10 à 18, dans lequel chaque couche de guidage de l'ensemble s'étend suffisamment loin le long de l'axe de propagation pour que l'ensemble de couches de guidage présente un profil en escalier qui est sélectionné dans le groupe comprenant des profils linéaire, parabolique et exponentiel.

## FIG.1

InP 20

InGaAsP 21

InGaAsP 19

InP 18

InGaAsP 17

InP 16

15

InP 14

InGaAsP 13

InP 12

InGaAsP 11

InGaAsP

InP 10

## FIG.2

22       22

## FIG.3

30

30

## FIG.4

40
InP

x

x'

y

y'

PROPAGATION AXIS

# FIG.5

# FIG.6

TAPER
INPUT

60

61

TAPER
OUTPUT

x'  y'  y  x

# FIG.7

70

TAPER
INPUT

71

TAPER
OUTPUT

73

72

z'  x'  y'  y  x  z